# DEMANDE DE BREVET EUROPEEN

(11) **EP 0 528 715 A1**
(43) Date de publication de la demande: **24.02.1993**
(21) Numéro de dépôt: 92402225.4
(22) Date de dépôt: 04.08.1992
(51) Int. Cl.: H01L 29/76, H01L 29/40

(54) **Transistor à effet de champ à faible bruit**

(30) Priorité: 13.08.1991 FR 9110273
(71) Demandeur: THOMSON-CSF, 75008 Paris (FR)
(72) Inventeur: Schmidt, Poul, F-92045 Paris la Défense (FR)
(74) Mandataire: Taboureau, James

(57) **Abrégé**

L'invention concerne un transistor à effet de champ hyperfréquence de type à fil quantique dans lequel les électrons n'ont qu'une seul degré de liberté (1D).

Afin de diminuer les résistances d'accès, le canal (1D) est limité sous la grille (7) et formé par une pluralité de points quantiques (21) séparés entre eux par des trous (20). Les zones d'accès (18, 19) sont en semiconducteurs à deux degrés de liberté (TEGFET) ou en supraconducteurs.

Application aux transistors hyperfréquence.

## Description

La présente invention concerne un transistor à effet de champ, fonctionnant en hyperfréquence et ayant un faible bruit. Plus précisément, elle concerne un transistor à fils quantiques de longueur submicronique, et le procédé de fabrication de ce transistor.

On sait que le bruit est un défaut des transistors qui prend de l'importance lorsque la fréquence de travail du transistor augmente, Le domaine des hyperfréquences commence à 1 GHz, mais, au moment où l'invention a été faite, les circuits microondes, et les transistors qui les composent, travaillent plutôt à 20 ou 40 GHz : la puissance transmise à ces fréquences est très faible, et il importe que le signal transmis soit pur et non bruité.

Le bruit dans un transistor a de nombreuses causes, elles-mêmes d'origines variées et qu'on ne peut pas toujours contrôler. Cependant, il en est une que l'on peut maintenant maîtriser de mieux en mieux : c'est la dynamique des électrons dans le canal du transistor, on maîtrise des temps de transfert des porteurs de charges.

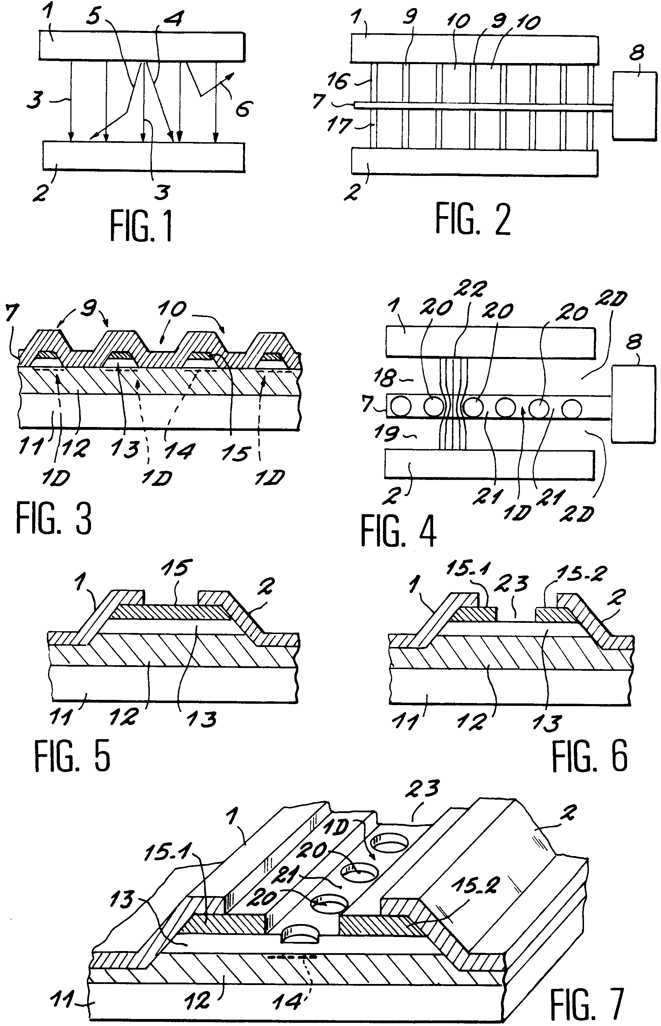

La figure 1 facilitera la compréhension du phénomène : elle est extrêmement simplifiée, et réduite aux deux métallisations 1 et 2 de source et drain d'un transistor, vues en plan. Si tous les électrons suivaient un itinéraire direct tel que 3, entre les deux électrodes d'accès, ils auraient tous le même temps de transit, et le signal électrique ne serait pas bruité. Mais dans la réalité, certains électrons prennent un itinéraire différent, et leur temps de transit est plus long : certains se déplaçant selon un chemin 4, entre deux points qui ne sont pas au plus près (cela peut être dû à la géométrie du transistor), d'autres sont diffusés en 5 par des collisions atomiques, ou même rétrodiffusés comme en 6. Ces longueurs différentes de chemins entraînent des temps de transit différents, donc du bruit dans le signal traité, qui est un phénomène comparable à une image optique floue parce que tous les rayons lumineux ne convergent pas dans le même plan.

En outre, il faut considérer que les itinéraires représentés en figure 1 se développent dans l'épaisseur de la couche active du transistor, donc dans trois dimensions (3D). Ainsi, les transistors dans lesquels les porteurs de charges électriques jouissent de trois degrés de liberté, tels que les MESFETS, MOSFETS, ... sont les plus bruyants. Les TEGFETS, dont le nom signifie précisément Two Dimensional Electron Gas Field Effect Transistor, sont moins bruyants parce que leurs électrons sont confinés dans un canal à deux dimensions (2D), contre l'hétérojonction, et les probabilité statistiques pour que les électrons aient des temps de transit différents sont moindres.

Le transistor le moins bruyant est donc - toutes choses étant égales par ailleurs - celui pour lequel pourra obliger les électrons à suivre un itinéraire sans déviations possibles et n'avoir plus qu'un seul degré de liberté (1D). Dans un tel transistor, la dynamique est la même pour tous les électrons, il n'y a plus de dispersion, plus de bruit lié à la dynamique.

Un tel transistor est connu, est appelé transistor à fils quantiques, ou "Striped-chanel FET" : il est représenté en plan en figure 2 et en coupe en figure 3.

Un transistor à fils quantiques est un dispositif semiconducteur qui comprend (figure 3), supporté par un substrat 11, une hétérojonction formée entre un matériau 12, peu dopé, à petite bande interdite (n.i.d GaAs), et un matériau 13, très dopé, à large bande interdite (n+AlGaAs). Il se forme un gaz d'électrons 14 à deux dimensions quantiques (2D), dans le matériau peu dopé (n.i.d GaAs). Accessoirement, une couche 15 de matériau très dopé (n+GaAs) est déposée en surface, pour la reprise de contact électrique avec les métallisations 1, 2 ou 7.

La caractéristique du transistor à fils quantiques réside en ce que sa surface, du côté couches actives, est gravée, jusqu'à la profondeur de l'hétérojonction, pour former des mésas 9, très étroits, séparés par des cuvettes ou recess 10. Les mésas 9 ont environ 0,25 micromètre de largeur, et 3 micromètres de longueur entre source et drain : ils se comportent comme des guides pour les électrons, et dans ces conditions, les gaz d'électrons 14, sous les mésas, n'ont qu'un seul degré de liberté quantique (1D).

Néanmoins, si la métallisation 7 de la grille a une longueur (électronique) de l'ordre 0,25 micromètre, les longueurs 16 et 17 des fils quantiques 9 qui ne sont pas recouvertes par la grâce constituent la majeure partie des fils quantiques, ce qui signifie que les résistances d'accès de source et de drain R_{SG} et R_{DG} sont élevées.

L'invention propose une amélioration des transistors à fils quantiques par modification de leur structure, qui entraîne une modification de leurs résistances d'accès. Selon l'invention, la longueur utile des fils quantiques 1D est réduite à la seule longueur de la grille, et les régions d'accès situées entre source et grille d'une part, entre drain et grille d'autre part, sont très conductrices pour abaisser les résistances d'accès : ces régions sont soit à structure TEGFET 2D, soit en supraconducteurs. Sous la métallisation de grille, les fils quantiques sont séparés entre eux par des trous dans les couches de la structure 2D.

De façon plus précise, l'invention concerne un transistor à effet de champ à faible bruit, comportant une structure à haute mobilité électronique formée à l'hétérojonction d'au moins deux couches de matériaux semiconducteurs, ce transistor étant caractérisé en ce que, sous la grille, le canal conducteur est formé par au moins un point quantique, de dimensions submicroniques, à un seul degré de liberté quantique, compris entre deux trous, à forte résistivité, sous la métallisation de grille, qui sont creusés dans les couches de matériaux semiconducteurs.

L'invention sera mieux comprise par la description qui suit d'un exemple d'application et d'un procédé de réalisation, en liaison avec les figures jointes en annexe, qui représentent :
- figure 1 : schéma de transfert des électrons entre source et drain, dans un transistor ;
- figures 2 et 3 : vues en plan et en coupe d'un transistor à fils quantiques selon l'art connu ;
- figure 4 : vue en plan d'un transistor à points quantiques selon l'invention ;
- figures 5 à 7 : principales étapes de fabrication d'un transistor à points quantiques selon l'invention.

La figure 4 représente une vue en plan d'un transistor selon l'invention : elle est extrêmement simplifiée, et limitée aux seuls éléments nécessaires à la compréhension de l'invention.

Un transistor selon l'invention comporte, supportées par un substrat non-intentionnellement dopé (n.i.d), des couches semiconductrices qui forment une hétérojonction TEGFET qui impose que les électrons n'ont que deux degrés de liberté quantique, dans l'espace entre la source et le drain 1 et 2. Le détail de ces couches se situe hors du domaine de l'invention : les matériaux peuvent être de type GaAs, Gaₓ Al₁₋ₓAs, Inp... etc, avec toutes les variantes possible de matériaux binaires, ternaires, quaternaires, et différentes valeurs des indices, et le nombre des couches peut comprendre des couches de lissage, des couches tampons, de prise de contact... etc. En première approximation, elle est comparable à relier qui est représentée en figure 3, et le produit de départ pour faire un transistor quantique selon l'invention est un bon transistor TEGFET. L'hétérojonction dans la couche active du transistor permet la formation d'un puits de potentiel très étroit où le vecteur d'onde des électrons est quantifié dans une direction produisant une réduction de dimension quantique du gaz électronique.

Le transistor est alors caractérisé par un gaz bidimensionel d'électrons, localisé dans un matériau non dopé, ce qui réduit les interactions avec les impuretés ionisées, donc améliore les propriétés de transport électronique, c'est-à-dire encore améliore la cinétique des électrons.

Dans le transistor selon l'invention, le gaz bidimensionnel d'électrons n'est utilisé pour dans les zones d'accès 18 et 19, entre source et grille et entre drain et grille. Sous la métallisation de grille 7, et seulement là, les électrons subissent une nouvelle quantification et le transport s'effectue dans au moins un canal unidimensionnel du type point quantique, parce qu'en fait c'est un fil quantique de longueur submicronique, aussi petite que sa largeur.

Ceci est obtenu au moyen de trous 20, creusés sous la métallisation de grâce 7 dans les couches superficielles 13 et 15 jusqu'à proximité du gaz d'électron, dans la couche 12 de matériau à faible bande interdite. Les trous 20 séparent ainsi une pluralité de canaux 21 qui ont une largeur (entre trous 20) de l'ordre de 0,05 à 0,25 micromètres, et une longueur (entre zones d'accès 18 et 19) comprise entre 0,1 et 0,5 micromètre. On sait qu'à ces dimensions, certaines interactions comme les interactions sur les impuretés ionisées sont différentes.

Par rapport à un transistor à fil quantique tel que décrit précédemment, le transistor selon l'invention présente des résistances d'accès R_{S} et R_{D} très faibles. En effet, si l'on se reporte à la figure 4 sur laquelle sont représentés en 22 quelques parcours d'électrons, on constate que, dans les zones d'accès 18 et 19, les électrons se déplacent dans un large gaz bidimensionnel 2D, comme dans un TEFGET, et non pas dans un fil quantique submicronique 16 et 17, comme en figure 2. Arrivés à hauteur de la grille 7, les parcours des électrons se resserrent pour franchir le point quantique 21, mais ces déviations n'entraînent pas un bruit aussi important que celui évoqué en figure 1.

Selon une variante de l'invention, les zones d'accès 18 et 19 peuvent être réalisées en matériaux supraconducteurs au lieu d'être en matériaux semiconducteurs : les supraconducteurs abaissent les résistances d'accès R_{S} et R_{D}′ et conservent la phase des électrons incidents.

Le procédé de réalisation d'un transistor selon l'invention est brièvement décrit au moyen des figures 5 à 7. Toutes les opérations ne sont pas détaillées et représentées, parce que ce sont toutes des opérations comprises dans l'état de l'art.

Ce procédé débute par la réalisation d'une structure Tegfet, en matériaux de type III-V, comportant sur un substrat 11, l'épitaxie d'au moins une couche 12 de matériau semiconducteur peu dopé à faible bande interdite et d'au moins une couche 13 de matériau semiconducteur dopé à large bande interdite. De préférence, une couche 15 de matériau dopé n+ est épitaxiée en surface : elle facilite la prise de contacts ohomiques. Comme représenté en figure 5, cette plaquette épitaxiée est gravée pour définir un mésa, et les contacts ohmiques 1 et 2 de source et drain sont déposés.

A l'emplacement de la future grille 7, un sillon 23 est d'abord défini par masquage électronique puis gravé par voie humide ou sèche. Ce sillon 23 est creusé sur toute l'épaisseur de la couche 15 de prise de contact, qu'il sépare en deux bandes 15-1 et 15-2 le long des métallisations 1 et 2 (figure 6).

Par une seconde opération identique de masquage électronique et gravure sèche ou humide sont définis les trous 20 et les points quantiques 21. Les trous 20 de forme carrée ou ronde, sont gravés sur la totalité on une fraction de l'épaisseur de la couche 13 de matériau à large bande interdite, de telle sorte qu'il est impossible de faire passer un courant sous un point gravé 20 : le canal conducteur 21 qui se forme entre deux points gravés 20 est un point quantique à un seul degré de liberté, si les dimensions sont suffisamment petites (environ 0,05 à 0,1 micromètre) pour que les électrons y subissent une quantification à 1D (figure 7).

Une grille Schottky est déposée sur les points quantiques 21 et, accessoirement, dans les trous 20. Elle n'est pas représentée sur la figure 7, pour faciliter la perspective, mais son profil est de même type que celui de la grille 7 en figure 3.

En raison de l'unique degré de liberté laissé aux électrons, ce transistor est appelé UNIFET.

## Revendications

**1 -** Transistor à effet de champ à faible bruit, comportant une structure à haute mobilité électronique (14) formée à l'hétérojonction d'au moins deux couches (12, 13) de matériaux semiconducteurs, ce transistor étant caractérisé en ce que, sous la grille (7), le canal conducteur est formé par au moins un point quantique (21), de dimensions submicroniques, à un seul degré de liberté quantique (11), compris entre deux trous (20), à forte résistivité, qui, sous la métallisation de grille (7), sont creusés dans les couches de matériaux semiconducteurs (13).

**2 -** Transistor selon la revendication 1, caractérisé en ce que les zones d'accès (18, 19) entre source et grille (1, 7 ) et entre drain et grille (2, 7) sont formées par une structure semiconductrice (12, 13) à gaz bidimensionnel (2D) d'électrons (14) à très faible résistivité, en vue de diminuer les résistances d'accès (R_{S}, R_{D}).

**3 -** Transistor selon la revendication 2, caractérisé en ce que la structure à deux degrés de liberté (2D) des zones d'accès (18, 19) et la structure à un seul degré de liberté (1D) du canal (21) sont formées dans les mêmes couches (12, 13) de matériaux semiconducteurs de type III-V, une première couche (12) étant peu dopée et à faible bande interdite, et une deuxième couche (13) étant très dopée et à large bande interdite.

**4 -** Transistor selon la revendication 1, caractérisé en ce que les zones d'accès (18, 19) entre source et grille (1, 7) et entre drain et grille (2, 7) sont formées par les matériaux supraconducteurs, en vue le diminuer les résistances d'accès (R_{S}, R_{D}).

**5 -** Transistor selon la revendication 1, caractérisé en ce que chaque point quantique (21) a une dimension comprise entre 0,1 et 0,5 micromètres, dans l'axe source-drain, et comprise entre 0,05 et 0,25 micromètre, entre deux trous (20), ces dimensions étant nécessaires à une double quantification des électrons.
